# EUROPÄISCHE PATENTSCHRIFT

(11) **EP 1 202 283 B1**
(45) Veröffentlichungstag und Bekanntmachung des Hinweises auf die Patenterteilung: **02.05.2007**
(21) Anmeldenummer: 01121390.7
(22) Anmeldetag: 06.09.2001
(51) Int. Cl.: G11C 11/16

(54) **MRAM-Anordnung**
MRAM memory device
Dispositif de mémoire MRAM

(30) Priorität: 11.10.2000 DE 10050365
(43) Veröffentlichungstag der Anmeldung: 02.05.2002
(73) Patentinhaber: Qimonda AG, 81739 München (DE)
(72) Erfinder: Viehmann, Hans-Heinrich, Wappingers Falls, NY 12590 (US)
(74) Vertreter: Müller - Hoffmann & Partner

(56) Entgegenhaltungen:
- US-B1- 6 490 217
- US-B2- 6 462 980

## Beschreibung

Die vorliegende Erfindung betrifft eine MRAM-Anordnung (MRAM = magnetoresistiver RAM) mit einem Speicherzellenfeld aus einer Vielzahl von Speicherzellen, die jeweils an Kreuzungsstellen von einerseits Wort- bzw. Gateleitungen und Programmierleitungen und andererseits Bitleitungen liegen und jeweils aus einer MTJ-Zelle (MTJ = magnetischer Tunnelübergang) und einem Auswahltransistor bestehen.

In einer MTJ-Zelle sind bekanntlich eine hartmagnetische Schicht, eine Tunnelbarrierenschicht und eine weichmagnetische Schicht übereinander gestapelt. Die MTJ-Zellen liegen an den Kreuzungsstellen der Programmierleitungen mit den Bitleitungen. Der Speicherinhalt einer MTJ-Zelle wird durch ihren Widerstandswert bestimmt: sind die hartmagnetische Schicht und die weichmagnetische Schicht in gleicher Richtung parallel zueinander magnetisiert, so ist der Widerstandswert der MTJ-Zelle niedriger als bei einer antiparallelen Magnetisierung. Die Magnetisierungsrichtung in der weichmagnetischen Schicht kann umgekehrt werden, indem Ströme in entsprechenden Richtungen durch die einer MTJ-Zelle zugeordneten Programmier- und Bitleitungen geschickt wird. Dabei muss zumindest in einer dieser Leitungen - in der Regel in der Programmierleitung - die Stromrichtung umkehrbar sein. Der niedrige und der hohe Widerstandswert der MTJ-Zelle kann dann einem Informationsinhalt "1" bzw. "0" oder umgekehrt zugeordnet werden.

Das Programmieren bzw. Einschreiben einer Speicherzelle geschieht nun in der Weise, dass bei nichtleitendem Auswahltransistor durch die zu dieser Speicherzelle zugehörigen Bit- und Programmierleitungen Ströme in solcher Stärke und Richtung geschickt werden, dass die von diesen Strömen erzeugten Magnetfelder die MTJ-Zelle in den niederohmigen Zustand (parallele Magnetisierungsrichtung) in weichmagnetischer Schicht und hartmagnetischer Schicht) oder in den hochohmigen Zustand (antiparallele Magnetisierung in weichmagnetischer Schicht und hartmagnetischer Schicht) bringen.

Für das Auslesen einer Speicherzelle wird die Programmierleitung nicht benötigt. Vielmehr wird hier der Auswahltransistor leitend geschaltet und an die Bitleitung ein bestimmtes Potential angelegt, so dass durch die MTJ-Zelle ein Strom fließt, dessen Größe vom Widerstandswert, also vom Informationsinhalt, der Zelle abhängt. Durch Auswerten dieses Stromes kann also der Speicherinhalt ausgelesen werden

Eine solche MRAM-Anordnung wird z.B. in Scheuerlein et al., "A 10ns Read and Write Non-volatile Memory Array using a Magnetic Tunnel Junction and FET Switch in Each Cell", ISSCC 2000, Seiten 128-129 offenbart.

Wie bereits oben erwähnt wurde, müssen beim Programmieren der Speicherzellen einer MRAM-Anordnung alle Gates der Auswahltransistoren auf Masse gelegt werden, um diese nichtleitend zu schalten. Dabei wird angenommen, dass die Auswahltransistoren n-Kanal-MOS-Transistoren sind. Denn nur bei abgeschalteten Auswahltransistoren kann verhindert werden, dass zusätzliche Ströme durch die MTJ-Zellen fließen, welche deren Programmierung verfälschen oder sogar unmöglich machen würden. Um ein schnelles Schalten des Auswahltransistors zu ermöglichen, muss die die Gates verbindende Gate- bzw. Wortleitung niederohmig angeschlossen sein.

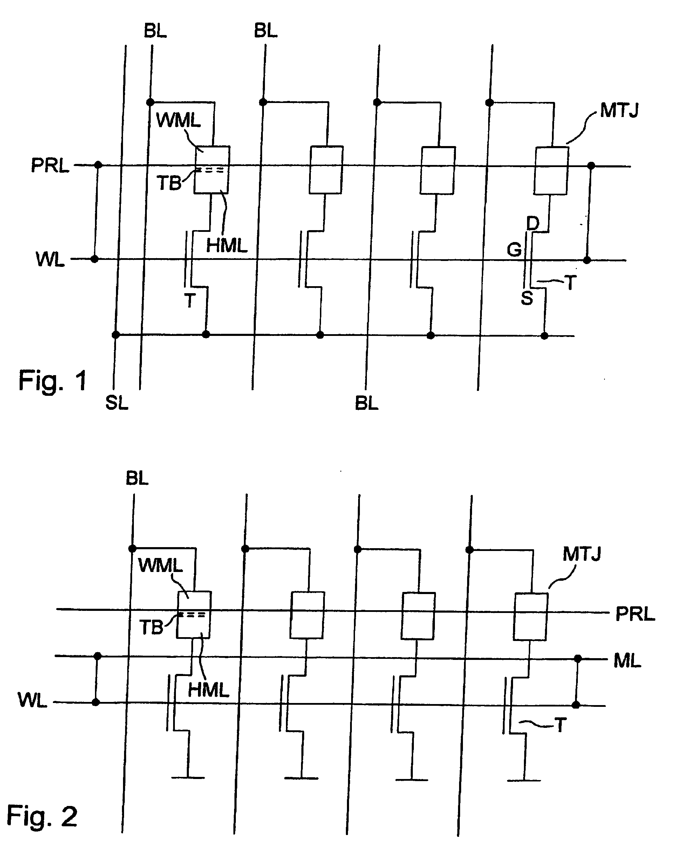

Fig. 2 zeigt ein Schaltbild einer bestehenden Anordnung, die die Forderung eines niederohmigen Anschlusses der Gateleitung erfüllt:

Speicherzellen bestehen jeweils aus einer MTJ-Zelle MTJ und einem Auswahltransistor T. Die MTJ-Zellen mit einer weichmagnetischen Schicht WML, einer Tunnelbarrierenschicht TB und einer hartmagnetischen Schicht HML liegen an Kreuzungsstellen von Programmierleitungen PRL (Programmierleitung in X-Richtung) und Bitleitungen BL (Programmierleitung in Y-Richtung).

Eine Gateleitung WL aus beispielsweise polykristallinem Silizium verbindet die Gates der Auswahltransistoren T einer Zeile miteinander. Um diese Gateleitung WL niederohmig anzuschließen, verläuft parallel zu ihr eine zusätzliche Metalleitung ML, die mindestens nach wenigen Auswahltransistoren niederohmig mit der Gateleitung WL verbunden ist.

Auf diese Weise können die Gates der Auswahltransistoren T zuverlässig und schnell auf Masse gelegt werden, um so die Auswahltransistoren T abzuschalten und ein Programmieren einer ausgewählten MTJ-Zelle vornehmen zu können, indem durch die dieser MTJ-Zelle zugeordnete Bitleitung BL und ebenfalls zugeordnete Programmierleitung PRL entsprechende Ströme geschickt werden.

Eine solche zusätzliche Metalleitung ML gewährleistet zwar einen niederohmigen Anschluss der Gateleitung WL. Sie erfordert aber relativ viel Fläche und vergrößert den notwendigen Bereich einer Zelle, die sogenannte Zellenfläche, um etwa 50 %, was äußerst unerwünscht ist.

Es ist daher Aufgabe der vorliegenden Erfindung, eine MRAM-Anordnung zu schaffen, bei der die Auswahltransistoren beim Programmieren bzw. Einschreiben zuverlässig abgeschaltet werden können, wobei aber keine Fläche für eine zusätzliche Metalleitung für einen niederohmigen Anschluss der Gateleitung benötigt werden soll.

Diese Aufgabe wird bei einer MRAM-Anordnung der eingangs genannten Art erfindungsgemäß dadurch gelöst, dass die Programmierleitung niederohmig mit der Wort- bzw. Gateleitung verbunden ist und dass beim Programmieren der Speicherzellen die von der MTJ-Zelle abgewandte Source- bzw. Drainelektrode der Auswahltransistoren auf ein die Auswahltransistoren sperrendes Potential, vorzugsweise auf das Potential der Programmierleitung legbar ist.

Bei der erfindungsgemäßen MRAM-Anordnung wird also die ohnehin vorhandene Programmierleitung dazu verwendet, die Gates der Auswahltransistoren auf ein solches Potential zu legen, dass diese nichtleitend sind. Da nun aber die Programmierleitung beim Programmieren der MTJ-Zellen auf einem Potential von etwa 1 V liegt, würden bei einer Verbindung der Gateleitung mit der Programmierleitung die Auswahltransistoren leitend werden, was nicht der Fall sein sollte, um die erwähnten zusätzlichen Ströme zu vermeiden. Diese zusätzlichen Ströme werden nun aber dadurch vermieden, dass die den MTJ-Zellen abgewandten und an sich mit Masse (Ground) verbundenen Elektroden der Auswahltransistoren, in der Regel deren Sources, ebenfalls auf 1 V gelegt werden. Mit anderen Worten, bei der erfindungsgemäßen MRAM-Anordnung werden beim Programmieren die Gates der Auswahltransistoren mit der Programmierleitung verbunden und die Sources auf das Potential der Gates bzw. der Programmierleitung gebracht, wodurch die unerwünschten Ströme durch die Auswahltransistoren unterbunden werden. Um dies zu erreichen, sind die Sources der Auswahltransistoren zusammengeschaltet und mit einer gemeinsamen Sourceleitung verbunden, die auf das Potential der Programmierleitung gelegt wird.

Anstelle der Sources können gegebenenfalls auch die Drains der Auswahltransistoren miteinander verbunden und auf das Potential der Gateleitung bzw. Programmierleitung gelegt sein, wenn die Sources der Auswahltransistoren an die MTJ-Zellen angeschlossen sind.

Nachfolgend wird die Erfindung anhand der Zeichnungen näher erläutert. Es zeigen:
- Fig. 1: ein Schaltbild der erfindungsgemäßen MRAM-Anordnung und
- Fig. 2: ein Schaltbild einer bestehenden MRAM-Anordnung.

Fig. 2 ist bereits oben erläutert worden.

In Fig. 1 werden für einander entsprechende Bauteile die gleichen Bezugszeichen wie in Fig. 2 verwendet.

Wie aus Fig. 2 zu ersehen ist, sind bei der erfindungsgemäßen MRAM-Anordnung die eine Wortleitung WL bildenden polykristallinen Gates der Auswahltransistoren T niederohmig mit der Programmierleitung PRL verbunden. Um nun beim Programmieren einer MTJ-Zelle MTJ den zugehörigen Auswahltransistor t dennoch abzuschalten, obwohl dessen Gate mit der auf einem Potential von etwa 1 V liegenden Programmierleitung PRL verbunden ist, wird Source dieses Auswahltransistors T auf das gleiche Potential wie dessen Gate, also auf das Potential der Programmierleitung PRL gelegt. Hierzu sind die Sources S der Auswahltransistoren T einer Reihe der Speicherzellen miteinander verbunden und an eine Sourceleitung SL angeschlossen. Über diese Sourceleitung SL können so die Sources S der Auswahltransistoren T einer ausgewählten Reihe von Speicherzellen in einem Speicherzellenfeld auf das Potential der dieser Reihe zugeordneten Programmierleitung PRL gelegt werden. Anstelle des Potentials der Programmierleitung PRL kann auch ein anderes Potential gewählt werden, das die Auswahltransistoren T sperrt. Damit befinden sich Gate G und Source S der Auswahltransistoren T auf dem gleichen Potential, so dass zusätzliche Ströme zuverlässig zu vermeiden sind.

Wesentlich an der erfindungsgemäßen MRAM-Anordnung ist dabei, dass keine zusätzliche Metalleitung über das Speicherzellenfeld für jede Zeile geführt zu werden braucht, was eine erhebliche Flächeneinsparung bedeutet. Es ist vielmehr ausreichend, am Rand des Speicherzellenfeldes durch eine zusätzliche Sourceleitung die Möglichkeit zu schaffen, alle Auswahltransistoren T des Speicherzellenfeldes so zu schalten, dass bei diesen Gate G und Source S auf dem gleichen Potential sind.

Beim Programmieren einer MRAM-Anordnung wird jeweils nur die Programmierleitung PRL einer ausgewählten Zeile des Speicherzellenfeldes auf das Potential von etwa 1 V gebracht, während die Programmierleitungen der übrigen Zeilen des Speicherzellenfeldes auf 0 V verbleiben. Eine Anhebung der Sourcespannungen von nicht ausgewählten Zeilen auf etwa 1 V schadet nicht, so daß alle Sources der Auswahltransistoren mit der Sourceleitung SL verbunden werden können.

## Patentansprüche

1. Magnetoresistive RAM (MRAM) Anordnung mit einem Speicherzellenfeld aus einer Vielzahl von Speicherzellen (MTJ, T), die jeweils an Kreuzungsstellen von einerseits Wort- bzw. Gateleitungen (WL) und Programmierleitungen (PRL) und andererseits Bitleitungen (BL) liegen und jeweils aus einer Magnetischen Tunnelübergang Zelle (MTJ) und einem Auswahltransistor (T) bestehen **dadurch gekennzeichnet, dass**
die Programmierleitung (PRL) niederohmig mit der Wort- bzw. Gateleitung (WL) verbunden ist, und
beim Programmieren der Speicherzellen (MTJ, T) die von der MTJ-Zelle (MTJ) abgewandte Source- bzw. Drainelektrode (S) der Auswahltransistoren (T) auf das Potenzial der Programmierleitung (PRL) legbar ist, sodass die Auswahltransistoren (T) gesperrt sind.

2. MRAM-Anordnung nach Anspruch 1,
**dadurch gekennzeichnet, dass**
die Wort- bzw. Gateleitung (WL) aus polykristallinem Silizium besteht.

3. MRAM-Anordnung nach einem der Ansprüche 1 bis 2,
**dadurch gekennzeichnet , dass**
nach wenigstens zwei Speicherzellen (MTJ, T) eine niederohmige Verbindung zwischen der Wort- bzw. Gateleitung (WL) und der zugeordneten Programmierleitung (PRL) besteht.

4. MRAM-Anordnung nach einem der Ansprüche 1 bis 3,
**dadurch gekennzeichnet , dass**
das Potenzial der Programmierleitung (PRL) beim Programmieren etwa 1 V beträgt.

5. MRAM-Anordnung nach einem der Ansprüche 1 bis 4
**dadurch gekennzeichnet , dass**
die den MTJ-Zellen (MTJ) abgewandten Elektroden (S) der Auswahltransistoren (T) miteinander verbunden und an eine gemeinsame Leitung (SL) angeschlossen sind.

6. MRAM-Anordnung nach Anspruch 5,
**dadurch gekennzeichnet, dass**
die Sources (S) der Auswahltransistoren (T) an eine gemeinsame Sourceleitung (SL) angeschlossen sind.

## Claims

1. Magnetoresistive RAM (MRAM) arrangement having a memory cell array comprising a large number of memory cells (MTJ, T), which are each located at crossing points of word or gate lines (WL) and programming lines (PRL), on the one hand, and bit lines (BL), on the other hand, and each comprise a magnetic tunnel junction cell (MTJ) and a select transistor (T), **characterized in that** the programming line (PRL) has a low-resistance connection to the word or gate line (WL), and, during the programming of the memory cells (MTJ, T), the source and drain electrode (S) belonging to the select transistors (T) and facing away from the MTJ cell (MTJ) can be connected to the potential of the programming line (PRL), so that the select transistors (T) are turned off.

2. MRAM arrangement according to claim 1, **characterized in that** the word or gate line (WL) consists of polycrystalline silicon.

3. MRAM arrangement according to one of claims 1 and 2, **characterized in that** after at least two memory cells (MTJ, T), there is a low-resistance connection between the word or gate line (WL) and the associated programming line (PRL).

4. MRAM arrangement according to one of claims 1 to 3, **characterized in that** the potential of the programming line (PRL) during programming is about 1 V.

5. MRAM arrangement according to one of claims 1 to 4, **characterized in that** the electrodes (S) belonging to the select transistors (T) and facing away from the MTJ cells (MTJ) are connected to one another and to a common line (SL).

6. MRAM arrangement according to claim 5, **characterized in that** the sources (S) of the select transistors (T) are connected to a common source line (SL).

## Revendications

1. Dispositif RAM magnétorésistif (MRAM) comprenant un champ de cellules de mémoire constitué d'une pluralité de cellules de mémoire (MTJ, T) qui se trouvent respectivement aux points d'intersection, d'une part, de lignes (WL) de mot ou de grille ou de lignes (PRL) de programmation et, d'autre part, de lignes (BL) de bit, et qui sont constituées respectivement d'une cellule à jonction tunnel magnétique (MTJ) et d'un transistor (T) de sélection, **caractérisé en ce que** la ligne (PRL) de programmation est reliée à petite valeur ohmique à la ligne (WL) de mot ou de grille et
pour la programmation des cellules de mémoire (MTJ, T), l'électrode (S) de source ou de drain, qui est éloignée de la cellule MTJ (MTJ) des transistors T de sélection, peut être mise au potentiel de la ligne (PRL) de programmation, de sorte que les transistors (T) de sélection sont bloqués.

2. Dispositif MRAM suivant la revendication 1,
**caractérisé en ce que** la ligne (WL) de mot ou de grille est en silicium polycristallin.

3. Dispositif MRAM suivant l'une des revendications 1 à 2,
**caractérisé en ce qu'**après au moins deux cellules de mémoire (MTJ, T), il y a une liaison à petite valeur ohmique entre la ligne (WL) de mot ou de grille et la ligne (PRL) de programmation associée.

4. Dispositif MRAM suivant l'une des revendications 1 à 3,
**caractérisé en ce que** le potentiel de la ligne (PRL) de programmation est, lors de la programmation, d'environ 1 V.

5. Dispositif MRAM suivant l'une des revendications 1 à 4,
**caractérisé en ce** les électrodes (S), qui sont éloignées des cellules MTJ (MTJ) des transistors (T) de sélection, sont reliées entre elles et sont raccordées à une ligne (SL) commune.

6. Dispositif MRAM suivant la revendication 5,
**caractérisé en ce** la source (S) des transistors (T) de sélection est raccordée à une ligne (SL) de source commune.
